# FASCICULE DE BREVET EUROPEEN

(11) **EP 1 180 790 B1**
(45) Date de publication et mention de la délivrance du brevet: **17.10.2007**
(21) Numéro de dépôt: 01410105.9
(22) Date de dépôt: 16.08.2001
(51) Int. Cl.: H01L 21/02

(54) **Fabrication de condensateurs à armatures métalliques**
Kondensatorherstellung mit metallischen Elektroden
Fabrication of a capacitor with metal electrodes

(30) Priorité: 17.08.2000 FR 0010697
(43) Date de publication de la demande: 20.02.2002
(73) Titulaire: STMicroelectronics S.A., 92120 Montrouge (FR)
(72) Inventeur: Arnal, Vincent, 38000 Grenoble (FR); Torres, Joaquim, 38950 Saint Martin Le Vinoux (FR)
(74) Mandataire: de Beaumont, Michel

(56) Documents cités:
- EP-A- 0 862 203
- DE-A- 4 320 060

## Description

La présente invention concerne, de façon générale, la réalisation sous forme monolithique de condensateurs de forte capacité, par exemple de découplage ou de circuits résonants, comportant des armatures métalliques. La réalisation de tels condensateurs à déjà été décrite dans EP 0 862 203 A1. Plus particulièrement, la présente invention concerne la fabrication de tels condensateurs au moyen de métallisations d'interconnexion formées dans la partie supérieure d'un circuit intégré.

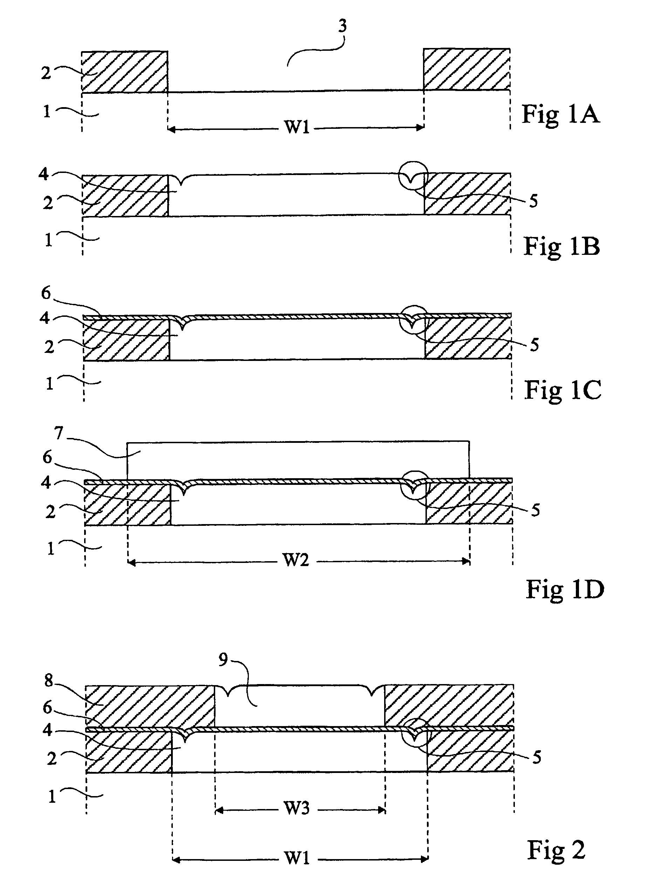

Les figures 1A à 1D illustrent, en vue en coupe partielle et schématique, un procédé de réalisation de tels condensateurs. Le procédé commence, comme l'illustre la figure 1A, par le dépôt, sur un substrat 1, d'une couche isolante 2 de façon que sa surface supérieure soit sensiblement plane. Le substrat 1 est constitué essentiellement d'une région isolante, qui peut comporter des contacts conducteurs verticaux ou vias. La couche 2 est ensuite gravée de façon à former une ouverture 3 à l'emplacement où doit être formé le condensateur.

Aux étapes suivantes, illustrées en figure 1B, on dépose une couche métallique 4 correspondant à une métallisation d'interconnexion et on effectue alors un polissage mécano-chimique (CMP) pour en laisser la partie contenue dans l'ouverture 13.

Lors des opérations successives de remplissage de l'ouverture 3 et d'aplanissement de la couche 4, il se forme généralement une encoche ou dépression 5 dans la surface de la couche métallique 4 au niveau de la zone de contact entre la couche 4 et la couche isolante 2. Cette encoche 5 peut avoir une profondeur de l'ordre de quelques dizaines de nanomètres. De plus, et bien que cela ne soit pas représenté aux figures, l'aplanissement du matériau 4 n'est généralement pas parfait. Sa surface supérieure présente une forme arrondie, en dôme.

A l'étape suivante, illustrée en figure 1C, on dépose et on grave une couche isolante 6 de très faible épaisseur, de l'ordre de quelques dizaines de nanomètres, destinée à constituer le diélectrique du condensateur.

Aux étapes suivantes, on forme une seconde électrode en regard de la première électrode.

Selon un mode de réalisation, illustré en figure 1D, on dépose et on grave une seconde couche métallique 7 de façon à lui conférer la forme voulue pour la seconde électrode. On a ainsi formé un condensateur dont deux armatures métalliques 4 et 7 sont séparées par un isolant 6.

Un inconvénient d'un tel procédé est que l'épaisseur de la couche 6 ne peut pas être réduite autant que souhaité. En effet, il faut assurer sa continuité entre les deux électrodes. Or il se trouve que l'encoche 5 présente une profondeur supérieure à l'épaisseur minimale de la couche 6 fixée par les critères d'isolation. Si la couche 6 est trop fine, elle risque de présenter des discontinuités dans l'encoche 5.

Pour éviter cet inconvénient, un autre procédé classique de formation d'un condensateur à deux armatures métalliques prévoit des étapes initiales similaires à celles décrites précédemment en relation avec les figures 1A à 1C. Toutefois, la seconde électrode n'est pas gravée directement mais formée par la répétition des étapes précédentes. Le résultat d'un tel procédé est illustré en figure 2.

Après le dépôt et la gravure de la couche diélectrique 6 décrit précédemment avec la figure 1C, on dépose et on ouvre une couche isolante 8. La couche 8 est similaire à la couche 2. La couche 8 est ouverte sur une largeur W3. Afin de garantir la non-couverture de la zone fragile comportant les encoches 5, la largeur W3 est inférieure à la largeur W1 de la première électrode 4. On dépose et on aplanit ensuite par CMP une couche métallique 9 d'un matériau similaire à celui de la couche 4, de la façon décrite précédemment en relation avec la figure 1C.

Par rapport au procédé précédent, ce procédé présente l'avantage d'éviter que la seconde électrode 9 recouvre la zone comportant l'encoche 5. En termes de capacité, cela permet d'éviter l'encoche 5 et les courants de fuite associés. Toutefois, ce procédé présente l'inconvénient que l'aplanissement par CMP de la couche 9 est relativement difficile. En effet, comme on l'a précisé précédemment, la surface supérieure de la couche 4 n'est pas plane. Ce défaut de planéité est reproduit par la couche 9, et cela accentue la complexité de gravure du matériau de la couche 9. En outre, la gravure de la couche isolante 8 en s'arrêtant sur l'isolant 6 risque de le dégrader.

De plus, quel que soit le procédé utilisé, la surface du condensateur est égale à celle de la plus petite des deux portions de couches d'interconnexion en regard et est limitée par la surface disponible au-dessus du circuit intégré.

Ainsi, à titre d'exemple non-limitatif, alors que la surface disponible pour créer un condensateur est comprise entre 100 et 10⁶ µm², typiquement de 10000 µm², la surface réelle de couplage capacitif est comprise entre 90 et 0,9.10⁶ µm², typiquement de 9900 µm². La capacité des condensateurs obtenus est alors comprise entre 0,1 et 10³ pF.

La présente invention vise à proposer un procédé de formation de condensateurs à armatures métalliques formés au-dessus d'un circuit intégré présentant pour une même surface d'intégration une capacité supérieure à celle obtenue par des procédés classiques par développement des surfaces en regard.

Un autre objet de la présente invention est de proposer un tel procédé qui évite les inconvénients de réalisation exposés précédemment.

Pour atteindre ces objets, la présente invention prévoit un procédé de formation d'un condensateur à armatures métalliques dans des niveaux de métallisation au-dessus d'un circuit intégré, comprenant les étapes suivantes :
a) déposer sur la surface d'un circuit intégré une couche isolante d'une épaisseur comprise entre 0,5 et 1,5 µm ;
b) creuser la couche isolante de façon à former des tranchées dont au moins une partie en vue de dessus est parallèle et disjointe d'une tranchée à l'autre ;
c) déposer et aplanir un matériau métallique de façon à former des lignes conductrices dans les tranchées ;
d) retirer localement la couche isolante de façon à l'éliminer au moins dans tous les intervalles séparant deux lignes conductrices ;
e) déposer de façon conforme un diélectrique ; et
f) déposer et graver un second matériau métallique de façon à au moins remplir complètement les intervalles interlignes.

Selon un mode de réalisation de la présente invention, l'étape a) de dépôt de la couche isolante est précédée de la formation dans le circuit intégré sous-jacent d'un plateau métallique, l'étape b) suivante de creusement de la couche isolante étant effectuée de façon que les tranchées découvrent toutes au moins partiellement ledit plateau métallique.

Selon un mode de réalisation de la présente invention, l'étape b) de creusement de la couche isolante est effectuée de façon à conférer aux tranchées, en vue de dessus, une forme de peigne.

Selon un mode de réalisation de la présente invention, les tranchées sont formées lors de l'étape b) de creusement de la couche isolante de façon à présenter en vue de dessus la forme de deux peignes interdigités.

Selon un mode de réalisation de la présente invention, l'étape d) de retrait de la couche isolante est effectuée sur une largeur donnée comprise entre 1 et 1,5 µm.

Selon un mode de réalisation de la présente invention, le diélectrique présente une épaisseur comprise entre 10 et 100 nm.

Selon un mode de réalisation de la présente invention, l'étape d) de retrait local de la couche isolante est effectuée de façon à dessiner en vue de dessus un peigne.

Selon un mode de réalisation de la présente invention, le second matériau métallique à l'étape f) est déposé et gravé de façon à découvrir les portions planes du diélectrique recouvrant les surfaces supérieures de la couche isolante et des lignes conductrices du premier matériau métallique.

Selon un mode de réalisation de la présente invention, le diélectrique est de l'oxyde de silicium ou de l'oxyde de tantale.

Selon un mode de réalisation de la présente invention, le premier matériau métallique est du cuivre, et le second matériau métallique est du titane ou du tungstène.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A à 1D illustrent, en vue en coupe partielle et schématique, un procédé classique de formation d'un condensateur à armatures métalliques ;
la figure 2 illustre en vue en coupe partielle et schématique, le résultat d'un autre procédé classique de formation d'un condensateur à armatures métalliques ;
les figures 3A à 3F illustrent un mode de réalisation d'un condensateur à armatures métalliques selon la présente invention, les figures 3A et 3C à 3F étant des vues en coupe et la figure 3B étant une vue de dessus ;
les figures 4A et 4B illustrent, partiellement et schématiquement, en vue en coupe et en vue de dessus, respectivement, un condensateur à armatures métalliques selon un autre mode de réalisation de la présente invention ;
la figure 5 illustre, en vue en coupe partielle et schématique, un autre mode de réalisation de la présente invention ; et
la figure 6 illustre, en vue de dessus partielle et schématique, un autre mode de réalisation de la présente invention.

Par souci de clarté, les mêmes éléments ont été désignés par les mêmes références aux différentes figures et, de plus, comme cela est habituel dans la représentation des circuits intégrés, les diverses figures ne sont pas tracées à l'échelle.

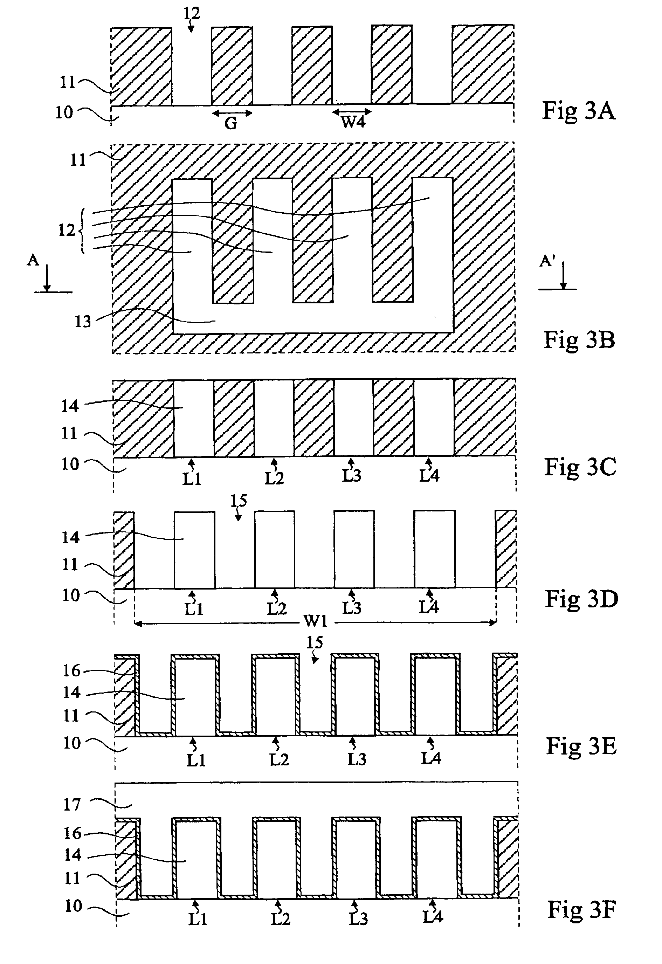

Un premier mode de réalisation de la présente invention est décrit ci-après en relation avec les figures 3A à 3F. Les figures 3A et 3C à 3F sont des vues en coupe partielles et schématiques d'un circuit intégré en différentes étapes de réalisation d'un condensateur à armatures métalliques. La figure 3B est une vue de dessus partielle et schématique de la structure à la fin de l'étape décrite en relation avec la figure 3A.

Comme l'illustre la figure 3A, le procédé selon l'invention commence par le dépôt, sur un circuit intégré 10, d'une couche isolante épaisse 11. La région supérieure du circuit intégré 10, illustrée en figure 3, est une région isolante. Cette région isolante est soit une région isolante entre des niveaux de métallisation d'interconnexion, soit une couche de séparation entre des dispositifs sous-jacents et le premier niveau d'interconnexion métallique. La couche isolante 11 est plus épaisse qu'une couche homologue classique (2, figure 1 ; 2 et 8, figure 2) dans une technologie donnée. On creuse ensuite dans la couche isolante 11 des tranchées parallèles 12. Les tranchées 12 sont formées dans toute l'épaisseur de la couche 11. Les tranchées 12 sont équidistantes, de faible largeur W4 et séparées d'un écart G du même ordre de grandeur que la largeur W4.

Selon un mode de réalisation, les tranchées 12 sont interconnectées par une tranchée perpendiculaire 13. En vue de dessus, comme l'illustre partiellement et schématiquement la figure 3B, on forme donc une ouverture en forme de peigne. L'axe A-A' de la figure 3B est l'axe de coupe des figures 3A et 3C à 3F.

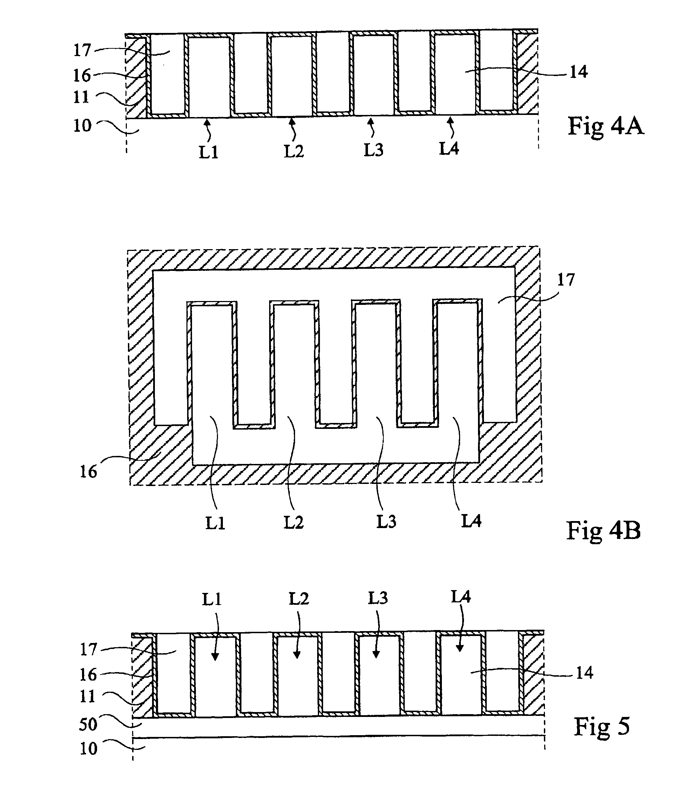

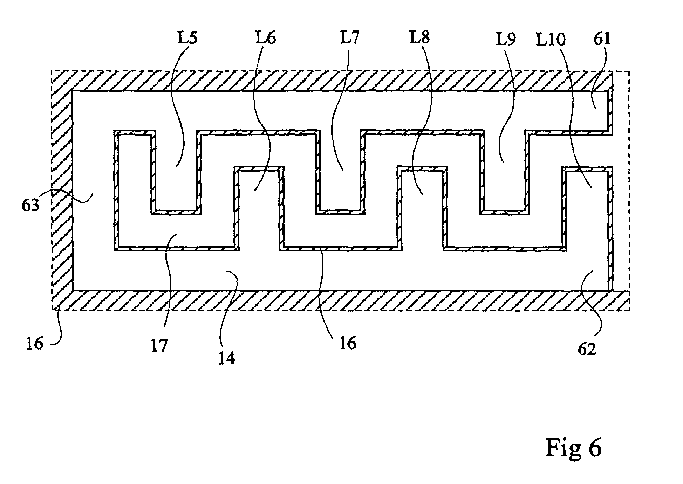

Aux étapes suivantes, illustrées en figure 3C, on dépose un premier matériau métallique 14 de façon à remplir complètement les tranchées 12. Le matériau 14 est un matériau fortement conducteur tel que du cuivre ou un alliage à base de cuivre. Le matériau 14 est ensuite aplani par un polissage mécano-chimique (CMP). On forme ainsi des lignes métalliques de mêmes dimensions et équidistantes. La figure 3 illustre à titre d'exemple non-limitatif quatre telles lignes L1, L2, L3 et L4. Les lignes métalliques L1, L2, L3 et L4 sont interconnectées par le remplissage simultané de la tranchée perpendiculaire 13 illustrée en figure 3B. D'autres modes de réalisation d'une telle interconnexion seront décrits ultérieurement, notamment en relation avec les figures 5 et 6.

Compte tenu de l'alternance des matériaux isolants de la couche 11 et du matériau métallique 14, l'aplanissement des lignes L1-L4 est plus facile à réaliser que l'aplanissement d'une ligne d'une largeur relativement importante selon l'art antérieur (4, figure 1 ; 4 et 9, figure 2). De plus, s'il existe un arrondissement de la surface supérieure des lignes, celui-ci est excessivement réduit et négligeable par rapport au phénomène homologue des procédés classiques.

Aux étapes suivantes, on effectue un retrait de la couche isolante 11 dans la région de formation du condensateur. On élimine ainsi complètement les portions de la couche isolante 11 séparant les lignes métalliques L1-L4. D'où il résulte la formation de tranchées parallèles disjointes 15.

Selon une variante illustrée en figure 3D, on retire la couche 11 également de part et d'autre des lignes extrêmes L1 et L4, de façon à former également des tranchées de mêmes dimensions que les tranchées 15 séparant deux lignes voisines.

Plus généralement, ce retrait s'effectue sur toute la surface (largeur W1) du condensateur que l'on souhaite former. Les extrémités latérales de cette surface peuvent également être constituées des lignes extrêmes L1 et L4.

Aux étapes suivantes, illustrées en figure 3E, on dépose un diélectrique 16. Le diélectrique 16 est déposé de façon conforme dans les tranchées 15 ainsi que sur les lignes L1-L4. On notera que le très léger arrondissement des angles supérieurs des lignes L1-L4, permet avantageusement d'éviter une cassure du diélectrique qui risquerait de se produire avec une structure à angles droits. Le diélectrique 16 est choisi parmi les matériaux standards utilisés pour la réalisation de condensateurs. Il pourra s'agir d'un matériau paraélectrique ou ferroélectrique ou encore d'un isolant tel que, par exemple, l'oxyde de silicium (SiO₂), l'oxyde de tantale (Ta₂O₅) ou encore le nitrure de silicium (Si₃N₄).

Aux étapes suivantes, illustrées en figure 3F, on forme un deuxième niveau métallique d'interconnexion constitué d'un second matériau métallique 17. Le matériau 17 est déposé et gravé de façon à au moins remplir complètement les tranchées 15. Le matériau 17 est soit un matériau facilement gravable tel que, par exemple, du tungstène, du titane ou de l'aluminium, soit un matériau difficilement gravable par seule voie chimique tel que du cuivre ou un alliage à base de cuivre.

Selon un mode de réalisation illustré en figure 3F, le second matériau 17 est gravé de façon à déborder des tranchées 15. Le second matériau 17 présente alors une structure en peigne vertical dont les dents dirigées vers le bas sont intercalées entre les dents du peigne horizontal constitué par le premier matériau 14.

On a ainsi formé un condensateur à armatures métalliques verticales dans l'épaisseur de la couche 11, dont une première électrode est constituée du premier matériau 14, l'isolant inter-électrodes du diélectrique 16 et la seconde électrode du second matériau 17.

La présente invention permet d'obtenir à partir d'une même surface en vue de dessus, un condensateur d'une capacité supérieure à celle d'un condensateur obtenu à l'aide d'un procédé classique. En effet, alors que selon l'art antérieur la capacité était définie par la seule surface plane en regard des deux électrodes, selon l'invention, la majeure partie de la capacité est définie dans l'épaisseur de la couche 11, par les surfaces verticales en regard des dents interdigitées des première et seconde électrodes 14 et 17. Bien entendu, la capacité comporte également des composantes de couplage capacitif horizontal, notamment entre les parties supérieures planes des lignes et la partie horizontale de la seconde électrode 17.

Le procédé selon l'invention permet d'éviter la formation d'encoches et limite ainsi les courants de fuite.

Le procédé selon l'invention ne présente plus les problèmes de complexité d'aplanissement exposés précédemment.

En outre, les risques de mise en contact direct des deux électrodes par rupture du diélectrique inter-électrodes sont réduits.

Selon une variante illustrée en figure 4A, le matériau 17 est gravé, par exemple aplani, de façon à l'éliminer complètement du plan défini par les portions du diélectrique 16 recouvrant la surface supérieure de la couche 11 et des lignes L1-L4. Les différentes portions du matériau 17 ainsi maintenues en place sont alors interconnectées par le remplissage d'une tranchée supplémentaire perpendiculaire à toutes les tranchées 15. Cette tranchée supplémentaire est formée simultanément aux tranchées 15 lors de l'étape décrite précédemment de retrait de la couche isolante 11 (figure 3D).

La figure 4B illustre en vue de dessus partielle et schématique la structure de la figure 4A. On a formé une seconde électrode ayant la forme d'un peigne horizontal, dont les dents sont intercalées entre les lignes L1-L4.

Selon une variante, non représentée, les deux modes précédents de réalisation de la seconde électrode sont combinés.

Le choix de la forme de la seconde électrode (peigne horizontal, peigne vertical ou combinaison des deux formes) sera effectué en fonction des séquences de procédé standard dans lequel s'incorpore la réalisation d'un condensateur selon la présente invention. Ainsi, si au-dessus de la couche isolante 11, le procédé standard ne prévoit aucune réalisation de métallisation, le matériau 17 sera totalement éliminé au-dessus de celle-ci. Dans le cas contraire, il pourra être maintenu.

S'il est maintenu, on veillera lors de la formation de la première électrode à prévoir une prise de contact externe à la surface plane sur laquelle sera formé le plateau de la seconde électrode.

Selon un autre mode de réalisation de la présente invention, illustré en vue en coupe partielle et schématique en figure 5, les lignes L1-L4 du matériau 14 sont interconnectées au moyen d'un plateau métallique sous-jacent 50. Ce plateau métallique 50 est formé dans le circuit intégré 10 avant le dépôt de la couche isolante 11. Les tranchées 12 sont alors creusées de façon que toutes les tranchées 12 croisent le plateau 50, aucune tranchée perpendiculaire (13, figure 3B) n'étant creusée. On forme ainsi une première électrode en forme de peigne vertical, dont les dents pointent vers le haut. Le plateau 50 présente une surface comprise entre 100 et 10⁶ µm².

Selon un autre mode de réalisation, non représenté, il est possible de combiner les deux variantes précédentes d'interconnexion des lignes L1-L4. En termes de procédé, on forme alors dans le circuit intégré un plan métallique conducteur horizontal similaire au plateau 50 de la figure 5, puis on creuse des tranchées (12, 13) selon un motif en peigne horizontal similaire à celui illustré aux figures 3B et 4B.

La figure 6 illustre, en vue de dessus partielle et schématique, un autre mode de réalisation de la première électrode. Les lignes métalliques sont reliées en alternance à une de deux lignes perpendiculaires ou branches. Chaque ligne de la première électrode reliée à une branche est encadrée de deux lignes reliées à l'autre branche. Les deux branches sont ensuite interconnectées, soit comme l'illustre la figure 6 au même niveau, par une ligne extrême commune, soit à un niveau supérieur. La formation ultérieure d'une seconde électrode commune permet de réaliser des condensateurs en parallèle. Le gain de surface active est alors pratiquement doublé. En figure 6, on a représenté, de gauche à droite, à titre d'exemple non limitatif, six telles lignes L5, L6, L7, L8, L9 et L10. Les lignes L5, L7 et L9 sont reliées à une première branche 61, en haut de la figure 6. Les lignes L6, L8 et L10 sont reliées à une seconde branche 62, en bas de la figure 6. Les deux branches 61 et 62 sont interconnectées dans le même plan que les lignes L5, L6, L7, L8, L9 et L10 par une ligne supplémentaire 63, par exemple à gauche de la structure. La seconde électrode 17 est constituée du remplissage de l'intervalle séparant les deux branches 61 et 62. Comme précédemment, selon une variante non représentée, la seconde électrode peut comporter en outre une partie plane recouvrant l'ensemble de la structure, lui conférant une structure sensiblement en peigne vertical.

En outre, les modes de réalisation d'une première électrode des figures 5 et 6 peuvent être combinés. On formera alors dans le circuit intégré deux plateaux distants et chaque ligne contactera un seul de ceux-ci. Les deux plateaux seront interconnectés soit dans le circuit intégré, soit par une ligne commune, soit à un niveau supérieur.

A titre d'exemple non-limitatif, les différents matériaux utilisés pourront être :
- couche isolante 11 : oxyde de silicium, d'une épaisseur comprise entre 0,5 et 1,5 µm. A titre de comparaison, une zone isolante d'encapsulation d'un condensateur classique homologue (couches 2 et 8 figure 2) avait une épaisseur comprise entre 0,2 et 0,5 µm ;
- tranchées 12 : d'une largeur W4 comprise entre 0,15 et 0,3 µm ; et séparées d'un écart G compris entre 0,15 et 0,3 µm. On formera de une à mille tranchées ;
- retrait de la couche isolante 11 : sur une longueur comprise entre 10 et 5000 µm, de préférence de l'ordre de 100 µm; soit sur une surface plane totale comprise entre 50 et 10⁶ µm², de préférence de l'ordre de 10⁴ µm² ; et
- diélectrique 16 : oxyde de silicium ou oxyde de tantale, d'une épaisseur comprise entre 10 et 100 nm, de préférence de l'ordre de 50 nm.

Alors, pour une surface plane de l'ordre de 100 µm², en considérant que les première et seconde électrodes ont la forme de peignes horizontaux telle qu'illustrée en figure 4, la surface réelle de couplage est de l'ordre de 300 à 450 µm², soit un gain en surface de 3 à 5 par rapport à un condensateur classique réalisé dans une même surface plane.

Pour une première électrode constituée de deux peignes horizontaux interconnectés telle qu'illustrée en figure 6 et dans des conditions similaires à celles de l'exemple précédent :
- la seconde électrode étant constituée du seul remplissage de l'intervalle entre les deux branches de la première électrode, le gain de surface active du condensateur est alors porté à sensiblement 5 ; et
- la seconde électrode étant un peigne vertical, le gain est alors accru de la surface du plateau (non représenté).

Bien entendu, la présente invention est susceptible de diverses variantes et modifications qui apparaîtront à l'homme de l'art. En particulier, les exemples numériques indiqués précédemment sont liés à une technologie de fabrication particulière. Étant donné la tendance générale dans la fabrication des composants semiconducteurs, ces dimensions sont appelées à aller en décroissant.

En outre, l'homme de l'art saura conférer aux différentes électrodes les formes souhaitées afin d'optimiser la capacité. Par exemple, au lieu d'être en vue de dessus un peigne régulier à dents rectangulaires, on pourra réaliser une électrode ayant en vue de dessus une forme de ligne brisée ou en zigzag. Par ailleurs, l'homme de l'art saura modifier et compléter les motifs d'électrode décrits précédemment de façon à permettre la prise de contacts. L'homme de l'art saura également choisir et adapter les matériaux utilisés et leur dimension en fonction des contraintes d'une technologie de fabrication particulière, et des performances recherchées.

## Revendications

1. Procédé de formation d'un condensateur à armatures métalliques dans des niveaux de métallisation au-dessus d'un circuit intégré, **caractérisé en ce qu'**il comprend les étapes suivantes :
a) déposer sur la surface d'un circuit intégré (10) une couche isolante (11) d'une épaisseur comprise entre 0,5 et 1,5 µm ;
b) creuser la couche isolante de façon à former des tranchées (12) dont au moins une partie en vue de dessus est parallèle et disjointe d'une tranchée à l'autre ;
c) déposer et aplanir un premier matériau métallique (14) de façon à former des lignes conductrices (L1, L2, L3, L4 ; L5, L6, L7, L8, L9, L10) dans les tranchées ;
d) retirer localement la couche isolante de façon à l'éliminer au moins dans tous les intervalles (15) séparant deux lignes conductrices ;
e) déposer de façon conforme un diélectrique (16) ; et
f) déposer et graver un second matériau métallique (17) de façon à au moins remplir complètement les intervalles interlignes.

2. Procédé selon la revendication 1, **caractérisé en ce que** l'étape a) de dépôt de la couche isolante (11) est précédée de la formation dans le circuit intégré sous-jacent (10) d'un plateau métallique (50), l'étape b) suivante de creusement de la couche isolante étant effectuée de façon que les tranchées (12) découvrent toutes au moins partiellement ledit plateau métallique.

3. Procédé selon la revendication 1 ou 2, **caractérisé en ce que** l'étape b) de creusement de la couche isolante (11) est effectuée de façon à conférer aux tranchées (12), en vue de dessus, une forme de peigne.

4. Procédé selon la revendication 1 ou 2, **caractérisé en ce que** les tranchées (12) sont formées lors de l'étape b) de creusement de la couche isolante (11) de façon à présenter en vue de dessus la forme de deux peignes interdigités.

5. Procédé selon l'une quelconque des revendications 1 à 4, **caractérisé en ce que** l'étape d) de retrait de la couche isolante (11) est effectuée sur une largeur donnée (W1) comprise entre 1 et 1,5 µm.

6. Procédé selon l'une quelconque des revendications 1 à 5, **caractérisé en ce que** le diélectrique (16) présente une épaisseur comprise entre 10 et 100 nm.

7. Procédé selon l'une quelconque des revendications 1 à 3, **caractérisé en ce que** l'étape d) de retrait local de la couche isolante (11) est effectuée de façon à dessiner en vue de dessus un peigne.

8. Procédé selon l'une quelconque des revendications 1 à 7, **caractérisé en ce que** le second matériau métallique (17) est déposé et gravé à l'étape f) de façon à découvrir les portions planes du diélectrique (16) recouvrant les surfaces supérieures de la couche isolante (11) et des lignes conductrices (L1, L2, L3, L4 ; L5, L6, L7, L8, L9, L10) du premier matériau métallique (14).

9. Procédé selon l'une quelconque des revendications 1 à 8, **caractérisé en ce que** le diélectrique (16) est de l'oxyde de silicium ou de l'oxyde de tantale.

10. Procédé selon l'une quelconque des revendications 1 à 9, **caractérisé en ce que** le premier matériau métallique (14) est du cuivre, et le second matériau métallique (17) est du titane ou du tungstène.

## Claims

1. A method for forming a capacitor with metal armatures in metallization levels above an integrated circuit, **characterized in that** it includes the steps of:
a) depositing over the surface of an integrated circuit (10) an insulating layer (11) having a thickness ranging between 0.5 and 1.5 µm;
b) digging into the insulating layer to form trenches (12), of which at least a portion in top view is parallel and separate from one trench to the other;
c) depositing and leveling a metallic material (14) to form conductive lines (L1, L2, L3, L4; L5, L6, L7, L8, L9, L10) in the trenches;
d) locally removing the insulating layer to remove it at least from all the intervals (15) separating two conductive lines;
e) conformally depositing a dielectric (16); and
f) depositing and etching a second metallic material (17) to at least completely fill the intervals between lines.

2. The method of claim 1, **characterized in that** step a) of deposition of the insulating layer (11) is preceded by the forming in the underlying integrated circuit (10) of a metal plate (50), the next step b) of digging into the insulating layer being performed so that the trenches (12) reach said metal plate.

3. The method of claim 1 or 2, **characterized in that** step b) of digging into the insulating layer (11) is performed to give to the trenches (12), in top view, a comb shape.

4. The method of claim 1 or 2, **characterized in that** the trenches (12) are formed during step b) of digging into the insulating layer (11) to have in top view the shape of two interdigited combs.

5. The method of any of claims 1 to 4, **characterized in that** step d) of removal of the insulating layer (11) is performed across a given width (W1) ranging between 1 and 1.5 µm.

6. The method of any of claims 1 to 5, **characterized in that** the dielectric (16) has a thickness ranging between 10 and 100 nm.

7. The method of any of claims 1 to 3, **characterized in that** step d) of local removal of the insulating layer (11) is performed to draw a comb in top view.

8. The method of any of claims 1 to 7, **characterized in that** the second metallic material (17) is deposited and etched at step f) to expose the planar portions of the dielectric (16) covering the upper surfaces of the insulating layer (11) and conductive lines (L1, L2, L3, L4; L5, L6, L7, L8, L9, L10) of the first metallic material (14).

9. The method of any of claims 1 to 8, **characterized in that** the dielectric (16) is silicon oxide or tantalum oxide.

10. The method of any of claims 1 to 9, **characterized in that** the first metallic material (14) is copper, and the second metallic material (17) is titanium or tungsten.

## Patentansprüche

1. Ein Verfahren zum Bilden eines Kondensators mit Metallankern bzw. -armaturen in Metallisierungsebenen oberhalb einer integrierten Schaltung, **dadurch gekennzeichnet, dass** es die folgenden Schritte aufweist:
a) Abscheiden, über der Oberfläche der integrierten Schaltung (10), einer isolierenden Schicht (11), die eine Dicke im Bereich zwischen 0,5 und 1,5 µm besitzt;
b) Graben in die isolierende Schicht, um Gräben (12) zu bilden, von denen in der Draufsicht wenigstens ein Teil parallel und getrennt von einem Graben zu dem anderen ist;
c) Abscheiden und Nivellieren eines metallischen Materials (14), um leitende Leitungen (L1, L2, L3, L4; L5, L6, L7, L8, L9, L10) in den Gräben zu bilden;
d) lokales Entfernen der isolierenden Schicht, um sie wenigstens von allen der Intervalle (15) die zwei leitende Leitungen trennen, zu entfernen;
e) konformes Abscheiden eines Dielektrikums (16); und
f) Abscheiden und Ätzen eines zweiten metallischen Materials (17) um wenigstens komplett die Intervalle zwischen Leitungen zu füllen.

2. Verfahren nach Anspruch 1, **dadurch gekennzeichnet, dass** dem Schritt a) der Abscheidung der isolierenden Schicht (11) das Formen einer Metallplatte (50) in der zugrunde liegenden integrierten Schaltung (10) vorausgeht, der nächste Schritt b) des Grabens in die isolierende Schicht so durchgeführt wird, dass die Gräben (12) die Metallplatte erreichen.

3. Verfahren nach Anspruch 1 oder 2, **dadurch gekennzeichnet, dass** der Schritt b) des Grabens in die isolierende Schicht (11) durchgeführt wird, um den Gräben (12) in der Draufsicht eine Kammform zu geben.

4. Verfahren nach Anspruch 1 oder 2, **dadurch gekennzeichnet, dass** die Gräben (12) während des Schritts b) des Grabens in die isolierende Schicht (11) gebildet werden, so dass sie in der Draufsicht die Form von zwei verschränkten bzw. verzahnten Kämmen besitzen.

5. Verfahren nach irgendeinem der Ansprüche 1 bis 4, **dadurch gekennzeichnet, dass** der Schritt d) des Entfernens der isolierenden Schicht (11) über einer vorgegebenen Breite (W1), die sich zwischen 1 und 1,5 µm erstreckt, durchgeführt wird.

6. Verfahren nach irgendeinem der Ansprüche 1 bis 5, **dadurch gekennzeichnet, dass** das Dielektrikum (16) eine Dicke besitzt, die sich zwischen 10 und 100 nm erstreckt.

7. Verfahren nach irgendeinem der Ansprüche 1 bis 3, **dadurch gekennzeichnet, dass** der Schritt d) des lokalen Entfernens der isolierenden Schicht (11) durchgeführt wird, um in der Draufsicht einen Kamm zu zeichnen.

8. Verfahren nach irgendeinem der Ansprüche 1 bis 7, **dadurch gekennzeichnet, dass** das zweite metallische Material (17) im Schritt f) abgeschieden und geätzt wird zum Freilegen der planaren Anteile des Dielektrikums (16), die die oberen Oberflächen der isolierenden Schicht (11) und die leitenden Leitungen (L1, L2, L3, L4; L5, L6, L7, L8, L9, L10) des ersten metallischen Materials (14) abdeckt.

9. Verfahren nach irgendeinem der Ansprüche 1 bis 8, **dadurch gekennzeichnet, dass** das Dielektrikum (16) Siliziumoxid oder Tantaloxid ist.

10. Verfahren nach irgendeinem der Ansprüche 1 bis 9, **dadurch gekennzeichnet, dass** das erste metallische Material (14) Kupfer ist und das zweite metallische Material (17) Titan oder Wolfram ist.
